# EUROPEAN PATENT APPLICATION

(11) **EP 0 900 674 A1**
(43) Date of publication of application: **10.03.1999**
(21) Application number: 97925347.3
(22) Date of filing: 12.05.1997
(51) Int. Cl.: B44D 5/00, G03F 7/00

(54) **METHOD FOR FORMING A MICRO-RELIEF ON A METALLIC ARTICLE AND VARIANTS**

(30) Priority: 14.05.1996 RU 96108658
(71) Applicant: Kommercia Bank "Alba Alliance", 119146 Moscow (RU)
(72) Inventor: UKHANOV, Sergei Ivanovich, Moscow, 119146 (RU); IVANOV, Vladimir Valentinovich, Moscow, 127490 (RU); INKIN, Vitaly Nikolaevich, Moscow, 103482 (RU)
(74) Representative: Ziebig, Marlene, Dr. Dipl.-Chem.
(86) International application number: RU9700145
(87) International publication number: WO9743134

(57) **Abstract**

The usage is to process metals, to apply a photolithographic or holographic micro-relief onto a metal surface to mark articles. The essence of the invention is that in the first method variant a technique is described to obtain the micro-relief on the metal by pressing with the help of the nickel matrix from a foil, and in the second variant the description is given on the method for obtaining the micro-relief on the metal by an ion-beam etching of the metal with the argon in vacuum in the presence of the mask made of photoresist.

## Description

### Field of Invention

The invention relates to a metal processing technology and, more particularly, to methods for obtaining a micro-relief structure on a metal article surface, and can be utilized, for example, for marking the noble metal articles.

### Background Art

Known methods for metal processing, such as stamping, diamond cutting, electric spark processing etc. do not provide the obtaining of a micro-relief structure having a certain size of about 1 µm on a metal surface. Precisely on such structure the rainbow-painted images can be obtained due to interference, if the micro-relief is used as an information mark.

A method for obtaining the micro-relief structure being applied in a technique of copying the holograms is known (see, for example, "Optical Holography", edited by G. Kolfid, Moscow, "Mir", 1982, p. 307). According to this method a holographic micro-relief obtained in a regenerating medium is coated with a nickel layer of about 50 µm. In so doing, a matrix is formed which is used for high-speed stamping the full-color holograms on a heated transparent plastic.

However, an application of such matrix for obtaining the micro-relief on the metal surface leads to a distortion of an image being embedded into the micro-relief, since a force of pressing on a metal surface, increased in comparison with stamping a plastic material, causes an elastic deformation of the matrix micro-relief and subsequent distortion of the impression. A satisfactory result can be obtained only on a metal surface having a wall thickness comparable with the matrix thickness, i.e., on a metal foil.

A method for obtaining the micro-relief structure on articles from noble metals is known (RU, patent Nº 2055451, B41M 1/28, 1995). In the known method a photoresist layer is applied onto the metal surface, a required image is registered in the medium of this layer, for which purpose an amplitude modulation of a wave fell onto the photoresist is performed. After the registration of the image the photoresist is developed by its chemical processing, during which a soluble sections of the photoresist are removed, resulting in that the layer of the photoresist gets an appearance of the micro-relief structure in the form of grooves and ridges, onto which layer a layer of a transparent protective film is coated.

The required photoresist obtained by such method is held on the metal surface by the adhesive strength of the protective film, which appears to be insufficient for reliable preservation of the micro-relief structure from the destruction.

### Summary of Invention

An object of the invention is to develop a method (or its variants) for obtaining a micro-relief on the metal article in a layer of the metal itself. Realization of such method allows to perform not only a strong fixation of the micro-relief to the metal surface, but also to obtain copies of the micro-relief on other metal articles by pressing.

Said problem is solved by that in a first variant of the method for obtaining a micro-relief on the metal surface with the help of a matrix which pressing surface is implemented in the form of a foil made from nickel with a copy of the micro-relief, according to the invention, an article from the metal is previously heated and held at the temperature higher than the temperature of the metal recrystallization but lower than the temperature of its melting, and after that the step of stamping the article is performed by applying a pressing force having a stepped character to the article surface by means of the matrix, under which force the stage of growing the plastic deformation stress of the article material alternates with the stage of decreasing the stress.

An optimum mode in performing the method has such parameter values that the temperature, at which the heated metal article is held, accounts 70 per cent of the temperature of the metal melting, the holding time is 15 minutes, and the stepped character of the pressing force corresponds to a sequence 100-0-200-50-300 per cent of a change in the stress of the elastic deformation of the article material relatively to the value of the stress in the metal during its melting.

The said problem is also solved by that that in second variant of the method for obtaining a micro-relief on the metal surface, including steps of: applying a layer of the photoresist onto this surface, then optical modulating it, chemical proceeding the photoresist when its soluble sections are removed, after which the layer of the photoresist gets an appearance of the micro-relief structure in the form of ridges and grooves, according to the invention, after forming the micro-relief structure on the metal surface from not-removed sections of the photoresist, an ion-beam etching of the metal surface is performed by argon in vacuum on the sections from which the photoresist was removed.

For a number of metals, for example, the steel, the step of applying the layer of the photoresist onto the metal surface is performed by the way of its centrifuging until obtaining a layer of 1-2 µm in thickness, after which a layer thickness is uniformly decreased by the way of etching with argon ions up to a thickness of 0.5 to 1.0 µm, and a value of the required micro-relief is obtained within the range of 0.3 to 0.8 µm.

An optical modulation of the layer of the photoresist may be performed during a process of the photolithographic transfer of an image or its holographic registration.

Above-mentioned features relate to a group of inventions bound with a unified author conception, this group of inventions being consisted of objects of the same type and same purpose providing an obtaining of the same technical result, - forming the micro-relief in the metal thickness, which is a necessary con-dition for the invention presented by its variants.

### Preferred Embodiments of the Invention

The first variant of the method is implemented as follows.

A conductive coating is applied, for example, by silver chemically reduced from a solution, onto a micro-relief of a surface made, for example, in the form of a reflective hologram on a plastic material. Then, a nickel layer of a required thickness is applied galvanically onto the conductive coating, and after that an obtained nickel foil is separated from the surface micro-relief and used as a matrix for pressing on a metal. In order to decrease the effect of the matrix elastic deformation on the quality of the micro-relief impressing transferred onto the metal, an article is previously heated and held at the temperature higher than the temperature of the metal re-crystallization but lower than the temperature of its melting, and after that a stamping of the article is performed by applying a pressing force of stepped nature to its surface with the help of the matrix, at which force the step of growing a stress of the plastic deformation of the article material alternates with a step of decreasing the stress.

As it was shown by experimental researches, minimum distortions of the micro-relief on the metal surface took place in the case when the temperature at which the heated metal article is held, accounts approximately 70 per cent of the temperature of the metal melting, a holding time is of about 15 minutes, and a stepped nature of the pressing force corresponds to the sequence 100-0-200-50-300 per cent of the change in the stress of the elastic deformation of the article material relatively to the value of stress in the metal during its melting.

In order to perform the second variant of the method, the micro-relief on the metal is formed directly without help of the matrix, utilizing a process of photolithography or a technique used for a holographic recording of an image. In these both cases a micro-layer of a photoresist, for example, Shipley AZ- 1350 (a positive) or Kodak KOR (a negative), is applied onto the metal surface, in which micro-layer an optical modulation of a registering medium is performed. In the case of utilizing the photolithography process, such modulation is performed by a parameter of an amplitude of the light wave propagating from an object, which may be performed by exposing an elastic negative onto the photoresist. In the case of utilizing the holography process, an amplitude-phase modulation of the registering medium in the form of recording an interference field of a reference and object waves is performed. When illuminating the photoresist by a light, a chemical changes are occurred leading to its different solubility for different exposures. Depending on whether a photoresist being processed is negative or positive, a developer with a corresponding solvent assists to dissolve either unilluminated or illuminated section. Thus, the layer of the photoresist gets an appearance of a micro-relief structure in the form of ridges and grooves, where grooves correspond to metal surface sections from which the photoresist is removed. Then an ion-beam etching of the steel not-protected with the resist is performed by argon ions in vacuum. A degree of spraying a mask of the photoresist relatively to a given type of the metal is regulated by the temperature of the surface being processed.

In order to obtain a micro-relief on an article, for example, from the steel, the step of applying the layer of the photoresist onto the metal surface is performed by the way of its centrifuging until obtaining a layer of 1-2 µm in thickness, and after that the layer thickness is uniformly decreased by the way of etching it with argon ions up to a thickness of 0.5 to 1.0 µm, and a amount of the required micro-relief is obtained within the range of 0.3 to 0.8 µm. This particular case of obtaining the micro-relief on the metal allows to produce a matrix, for example, in the form of a steel plate, and further to utilize the matrix for applying a micro-relief impressing onto other metal articles. In comparison with the matrix in the form of the nickel foil used in the first variant of the method, such matrix does not subjected to the elastic deformation, and hence, a clear micro-relief impressing is formed on the metal while pressing. In addition, its depth assisting to increase the brightness of image embedded in the micro-relief, is increased.

The aforecited description of two method variants confirms the possibility of realizing the invention, since in so doing, means known on the date of creating the invention are used. Moreover, it is shown that the set of features characterized the invention essence is sufficient to solve the formulated problem.

### Industrial Applicability

The method for obtaining a micro-relief on a metal article may be employed in different management areas, for example, to mark the noble metal articles from a falsification, and also in manufacturing the holographic copies of means for the information storing and in other fields.

## Claims

1. A method for obtaining a micro-relief on a metal article, including the step of obtaining a mark impressing on the article surface with the help of a matrix which pressing surface is implemented in the form of a foil made from nickel with a copy of the micro-relief, *characterized* in that the article is previously heated and held at the temperature higher than the temperature of the metal recrystallization but lower than the temperature of its melting, and after that the step of stamping the article is performed by applying a pressing force having a stepped character to the article surface by means of the matrix, under which force the stage of growing the plastic deformation stress of the article material alternates with the stage of decreasing the stress.

2. The method for obtaining a micro-relief according to claim 1, *characterized* in that the temperature, at which the heated metal article is held, accounts 70 per cent of the temperature of the metal melting, the holding time is approximately 15 minutes, and the stepped character of the pressing force corresponds to a sequence 100-0-200-50-300 per cent of a change in the stress of the elastic deformation of the article material relatively to the value of the stress in the metal during its melting.

3. A method for obtaining a micro-relief on a metal article, including the steps of: applying a layer of a photoresist onto a surface of the article, subsequent optical modulating it, chemical processing the photoresist when its soluble sections are removed, after which the layer of the photoresist gets an appearance of the micro-relief structure in the form of ridges and grooves, *characterized* in that after forming the micro-relief structure on the metal surface from not-removed sections of the photoresist, an ion-beam etching of the metal surface is performed by argon in vacuum on the sections from which the photoresist was removed.

4. The method for obtaining a micro-relief according to claim 3, *characterized* in that the step of applying the layer of the photoresist onto the metal surface is performed by the way of its centrifuging until obtaining a layer of 1-2 µm in thickness, and after that a layer thickness is uniformly decreased by the way of etching with argon ions up to a thickness of 0.5 to 1.0 µm, and a value of the required micro-relief is obtained within the range of 0.3 to 0.8 µm.

5. The method for obtaining a micro-relief according to claims 3, 4, *characterized* in that the optical modulation of the layer of the photoresist is performed by a photolithographic transfer of an image.

6. The method for obtaining a micro-relief according to claims 3, 4, *characterized* in that the optical modulation of the layer of the photoresist is performed by a holographic registration of the image.
